(19) **Europäisches Patentamt**
**European Patent Office**
**Office européen des brevets**

(11) **EP 1 760 164 B1**

(12) **EUROPEAN PATENT SPECIFICATION**

(45) Date of publication and mention
of the grant of the patent:
**03.12.2008 Bulletin 2008/49**

(51) Int Cl.:
***C22C 19/05*** *(2006.01)*

(21) Application number: **06254484.6**

(22) Date of filing: **29.08.2006**

(54) **Nickel-base superalloy**

Nickel-Superlegierung

Superalliage de nickel

(84) Designated Contracting States:
**DE FR GB**

(30) Priority: **01.09.2005 US 162221**

(43) Date of publication of application:
**07.03.2007 Bulletin 2007/10**

(73) Proprietor: **GENERAL ELECTRIC COMPANY**
**Schenectady, NY 12345 (US)**

(72) Inventors:
• **Darolia, Ramgopal**
**West Chester**
**OH 45069 (US)**

• **Walston, William Scott**
**Cincinnati**
**OH 45241 (US)**
• **O'Hara, Kevin Swayne**
**Boxford**
**MA 01921 (US)**

(74) Representative: **Pedder, James Cuthbert et al**
**London Patent Operation,**
**General Electric International, Inc.,**
**15 John Adam Street**
**London WC2N 6LU (GB)**

(56) References cited:
**EP-A- 1 394 278          EP-A1- 0 434 996**
**EP-A1- 1 568 794          EP-A2- 1 057 899**
**US-A- 6 074 602**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

BACKGROUND OF THE INVENTION

The present invention generally relates to nickel-base alloys. More particularly, this invention relates to a nickel-base superalloy capable of being cast as a single-crystal article and exhibiting desirable properties for use in gas turbine engine applications.

The superalloy commercially known as René N6, disclosed in commonly-assigned U.S. Patent No. 5,455,120, has a nominal composition of, by weight, about 12.5% Co, 4.2% Cr, 7.2% Ta, 5.75% Al, 5.8% W, 5.4% Re, 1.4% Mo, 0.2% Hf, 0.05% C, 0.004% B, 0.01% Y, the balance nickel and incidental impurities. N6 is well known to have a number of very desirable properties for gas turbine engine applications, such as the high pressure turbine blades and vanes of aircraft gas turbine engines. EP 1 394 278 discloses a single crystal superalloy of 4-12% Co, 3.5-7% W, 2-9% Cr, 0.5-4.5% Ta, 5.5-7.5% Al, 0-5.5% Re, 0.1-1.2% Ti, 0-3% Mo, 0-3 Ru, 0.5-2% Nb, 0-0.01% B, about 0.07% C, 0.3-1% Hf, 0-0.01% Zr, 0-6.03% Y, 0-0.5% V, 0-0.01 Ce, 0-0.01 La and a balance of Ni.

As with the formulation of other superalloys, the composition of N6 is characterized by controlled concentrations of certain critical alloying elements to achieve a desired mix of properties. For use in gas turbine engine applications, such properties include high temperature creep strength, oxidation and corrosion resistance, resistance to low and high cycle fatigue (LCF and HCF), and single-crystal castability. While N6 performs well in applications within gas turbine engines, improvements would be desirable. Often of interest is the desire to reduce weight and cost, the latter of which is due in part to alloying constituents such as tantalum and rhenium. However, obtaining such reductions is difficult in view of the desire to maintain or often improve other properties of the alloy, including oxidation resistance and microstructural stability. With regard to the latter issue, microstructural instability is known to occur in various high strength superalloys when protected with coatings containing relatively high levels of aluminum, such as a diffusion aluminide environmental coating or bond coat. In particular, aluminum migration out of such coatings and into the underlying superalloy substrate can result in the formation of topologically close-packed (TCP) phases that, if present at sufficiently high levels, reduce the load-carrying capability of the alloy. The incidence of TCP phases has been associated with superalloys that contain significant amounts of refractory elements such as rhenium, tungsten, tantalum, hafnium, molybdenum, niobium, and zirconium.

BRIEF SUMMARY OF THE INVENTION

The present invention provides a nickel-base alloy that exhibits a desirable balance of high-temperature strength (including creep resistance), oxidation and corrosion resistance, resistance to low and high cycle fatigue, castability, and microstructural stability so as to be suitable for components of gas turbine engines, such as the high pressure turbine blades and vanes of gas turbine engines. These properties are achieved with an alloy that is lower in density than the superalloy known as René N6, and in which relatively higher levels of aluminum, tungsten, molybdenum, niobium (columbium), titanium, and hafnium are present and relatively lower levels of tantalum and rhenium are present as compared to N6.

According to the invention which is given in claim 1, the nickel-base alloy is in the form of a single-crystal casting consisting of, by weight, 5.75% to 6.5% aluminum, 4% to 5% tantalum, 2% to 6% chromium, 5.5% to 7% tungsten, 1.5% to 3% molybdenum, 4% to 5% rhenium, up to 1.0% niobium, 10% to 16% cobalt, up to 1% titanium, 0.01% to 0.05% carbon, up to 0.005% boron, up to 0.01% yttrium, 0.5% to 1.0% hafnium, the balance nickel and incidental impurities. Importantly, the density of the alloy is not more than 0.320 lbs/in$^3$ (about 8.87 g/cm$^3$).

As noted above, the nickel-base alloy of the present invention nominally contains more aluminum, tungsten, molybdenum, niobium, titanium, and hafnium and less tantalum and rhenium than N6. For the purpose of characterizing the alloy, these groups of alloys are designated as "delta addition" and "delta reduction" elements, respectively. According to the present invention, the ratio of delta addition to delta reduction elements (hereinafter, delta ratio) is less than 1.0. The limitation that the value of the delta ratio is less than unity reflects the determination of this invention that, contrary to conventional wisdom, the combination of (Al+Mo+W+Ti+Hf+Nb) is, by weight, a more potent strengthener than (Re+Ta).

The alloy of this invention is believed to have properties comparable to, and in some instances better than, those of the N6 alloy, particularly with the above-noted restriction on the delta ratio, which allows for lower tantalum and rhenium contents. Consequently, the alloy of this invention provides an excellent lower density (weight) and potentially lower-cost alternative to N6.

BRIEF DESCRIPTION OF THE DRAWINGS

The invention will now be described in greater detail, by way of example, with reference to the drawings, in which:-

Figure 1 depicts a high pressure turbine blade that can be formed from the nickel-base superalloy of the present invention.

Figures 2 through 7 are graphs plotting yield strength, tensile strength, (1800°F) rupture, 1090°C (2000°F) rupture, 1150°C (2100°F) rupture, and 870°C (1600°F) high cycle fatigue life of alloys prepared during investigations leading to the present invention.

DETAILED DESCRIPTION OF THE INVENTION

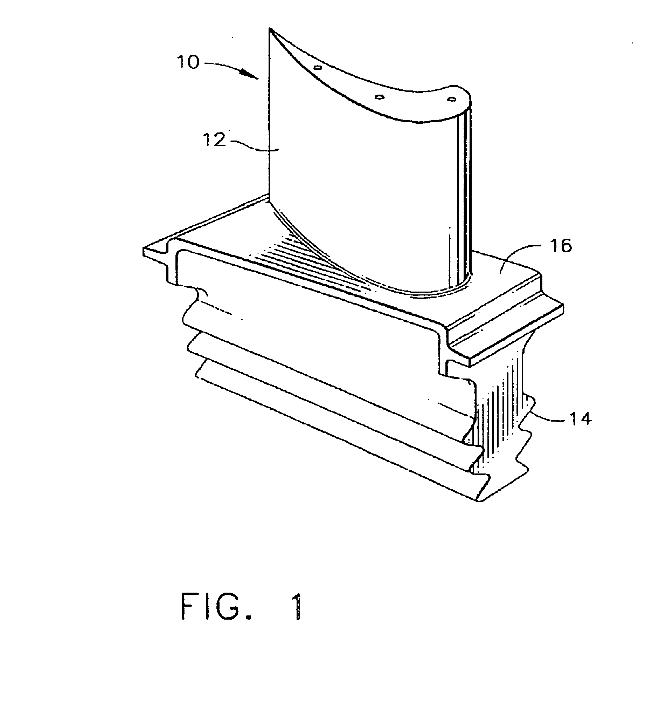

The present invention was the result of an effort to develop a nickel-base alloy having properties comparable to the nickel-base alloy commercially known as René N6, but with a chemistry that reduces the density and cost of the alloy while maintaining or improving high temperature strength (including creep resistance), oxidation resistance, fatigue resistance, castability, and microstructural stability (resistance to TCP formation) for use in such applications as the hot gas flow path of gas turbine engines. As an example, Figure 1 depicts a high pressure turbine (HPT) blade 10 having an airfoil 12, a dovetail 14 by which the blade 10 is anchored to a turbine disk (not shown), and a platform 16 therebetween. While the advantages of this invention will be described with reference to components of a gas turbine engine, such as the high pressure turbine blade 10 shown in Figure 1, the teachings of this invention are generally applicable to other components that require high temperature capabilities.

In a first round of investigations, alloys having the approximate chemistries set forth in Table I below were formulated. Specimens of various sizes were machined from single crystal slab castings that had been solution heat treated at about 2370°F (about 1300°C) for about six hours and then aged at about 1975°F (about 1080°C) for about four hours. The densities of the alloys were in the range of about 0.315 to 0.319 Ibs/in$^3$ (about 8.73 to about 8.84 g/cm$^3$), which is significantly less than the density of N6 (0.323 Ibs/in$^3$; about 8.95 g/cm$^3$). For reference, Table I also includes the nominal composition for N6.

TABLE I

|     | Al | Ta | Cr | W | Mo | Re | Nb | Co | Ti | C | B | Y | Hf | Ni |
|-----|-----|-----|-----|-----|-----|-----|-----|-----|-----|-----|-----|-----|-----|-----|
| N6 | 5.75 | 7.2 | 4.2 | 5.8 | 1.4 | 5.4 -- | -- | 12.5 | -- | 0.05 | 0.004 | 0.01 | 0.2 | bal. |
| 1* | 6.25 | 4.0 | 4.2 | 6.0 | 1.5 | 4.0 | 1.50 | 10.0 | 0.3 | 0.03 | 0.004 | 0.004 | 0.6 | 61.6 |
| 2 | 6.25 | 5.0 | 4.2 | 7.0 | 1.5 | 4.0 | 0.75 | 10.0 | 0.3 | 0.03 | 0.004 | 0.004 | 0.6 | 60.4 |
| 3* | 6.00 | 5.0 | 4.2 | 6.0 | 1.5 | 5.0 | 1.50 | 10.0 | 0.3 | 0.03 | 0.004 | 0.004 | 0.6 | 59.9 |
| 4* | 6.25 | 4.0 | 4.2 | 7.0 | 1.5 | 4.0 | 1.50 | 10.0 | 0.3 | 0.03 | 0.004 | 0.004 | 0.6 | 60.6 |
| 5 | 6.25 | 5.0 | 4.2 | 7.0 | 1.5 | 5.0 | 0.75 | 10.0 | 0.3 | 0.03 | 0.004 | 0.004 | 0.6 | 59.4 |
| 6* | 6.25 | 5.0 | 4.2 | 6.0 | 1.5 | 5.0 | 1.50 | 10.0 | 0.3 | 0.03 | 0.004 | 0.004 | 0.6 | 59.6 |
| 7* | 6.00 | 5.0 | 4.2 | 7.0 | 1.5 | 4.0 | 1.50 | 10.0 | 0.3 | 0.03 | 0.004 | 0.004 | 0.6 | 59.9 |
| 8* | 6.00 | 4.0 | 4.2 | 7.0 | 1.5 | 5.0 | 1.50 | 10.0 | 0.3 | 0.03 | 0.004 | 0.004 | 0.6 | 59.9 |
| 9 | 6.00 | 4.0 | 4.2 | 7.0 | 1.5 | 5.0 | 0.75 | 10.0 | 0.3 | 0.03 | 0.004 | 0.004 | 0.6 | 60.6 |
| 10 | 6.25 | 4.0 | 4.2 | 6.0 | 1.5 | 5.0 | 0.75 | 10.0 | 0.3 | 0.03 | 0.004 | 0.004 | 0.6 | 61.4 |
| 11 | 6.00 | 5.0 | 4.2 | 6.0 | 1.5 | 4.0 | 0.75 | 10.0 | 0.3 | 0.03 | 0.004 | 0.004 | 0.6 | 61.6 |
| 12 | 6.00 | 4.0 | 4.2 | 6.0 | 1.5 | 4.0 | 0.75 | 10.0 | 0.3 | 0.03 | 0.004 | 0.004 | 0.6 | 62.6 |
| 13* | 6.125 | 4.5 | 4.2 | 6.5 | 1.5 | 4.5 | 1.13 | 10.0 | 0.3 | 0.03 | 0.004 | 0.004 | 0.6 | 60.6 |
| 14* | 6.125 | 5.5 | 4.2 | 6.5 | 1.5 | 4.5 | 1.13 | 10.0 | 0.3 | 0.03 | 0.004 | 0.004 | 0.6 | 59.6 |
| * comparative alloys | | | | | | | | | | | | | | |

The above alloying levels were selected to evaluate the affects of adding the relatively lighter elements titanium and niobium, increasing the levels of tungsten, hafnium, and relatively lighter elements such as aluminum and molybdenum, and reducing the levels of heavier elements such as tantalum and rhenium in alloys based on N6. The approach of the investigation was also to maintain the total gamma-prime precipitation hardening phase while evaluating the affects of altering the amounts of rhenium, molybdenum, and tungsten that go into the gamma phase. As known in the art, the high-temperature strength of a nickel-base superalloy is directly related to the volume fraction of the gamma-prime phase, which in turn is directly related to the total amount of the gamma prime-forming elements (aluminum, titanium, tantalum, niobium, and hafnium) present. Based on these relationships, the composition and volume fraction of the gamma-prime phase and the amounts of the gamma prime-forming elements required to maintain a given strength level can be approximately estimated based on the starting chemistry of the alloy and some basic assumptions about the phases that form. It was initially viewed that an alloy having the desired level of creep strength for a HPT blade should contain at least as much gamma prime-forming elements (about 15.8 atomic percent of aluminum, tantalum, niobium, titanium, and hafnium combined) and as much gamma-forming elements (about 4.7 atomic percent of rhenium, molybdenum, and tungsten combined) as nominally contained in N6. However, other properties important to HPT blades and other hot gas flow path components, such as fatigue life, castability, metallurgical stability, and oxidation resistance, cannot be predicted from amounts of these and other elements.

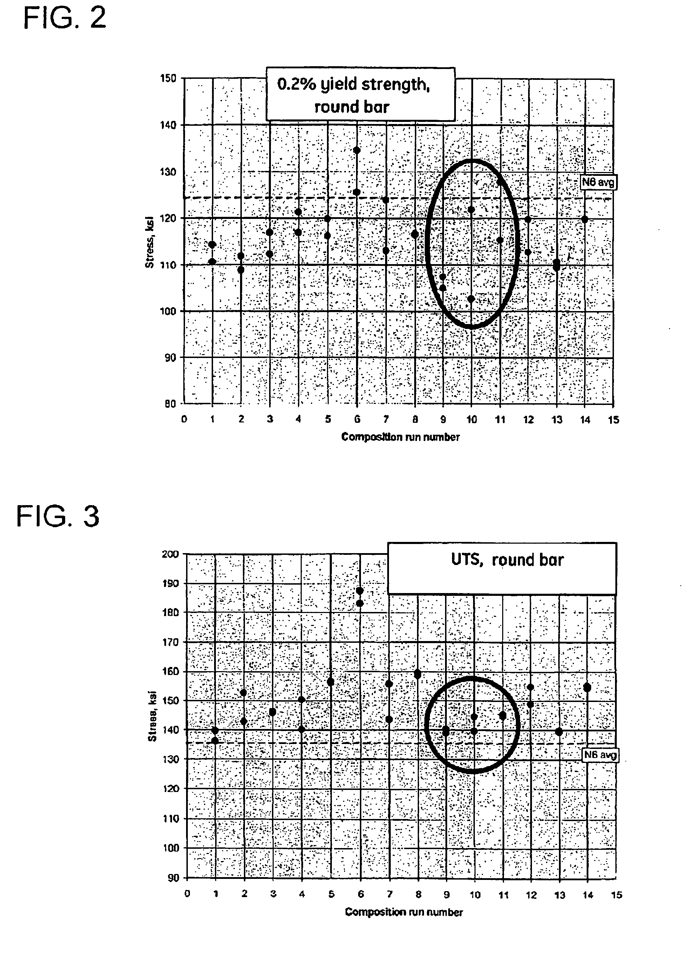

Tensile and yield strengths of the alloys are summarized in Figures 2 and 3, in which "N6 avg" identifies historical averages for N6. The data indicate that yield and tensile strengths of the specimens were similar to and generally higher than, respectively, N6.

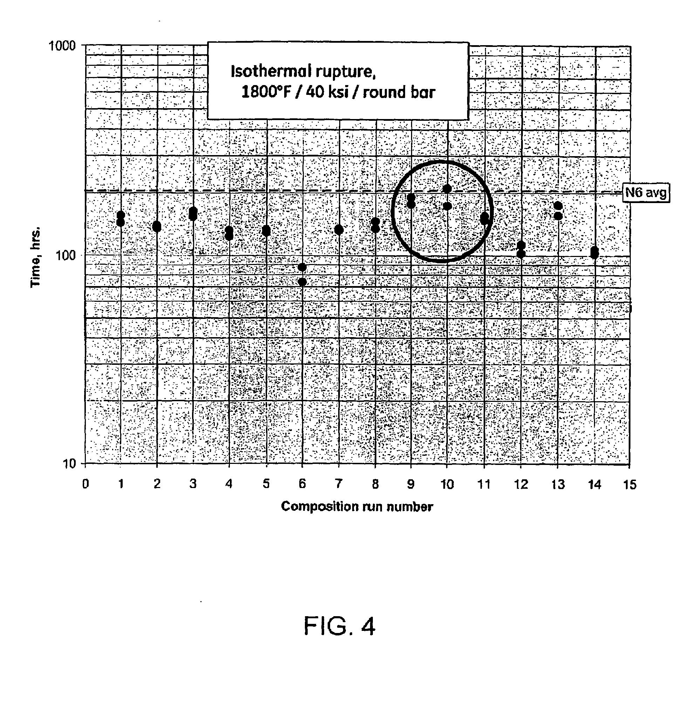

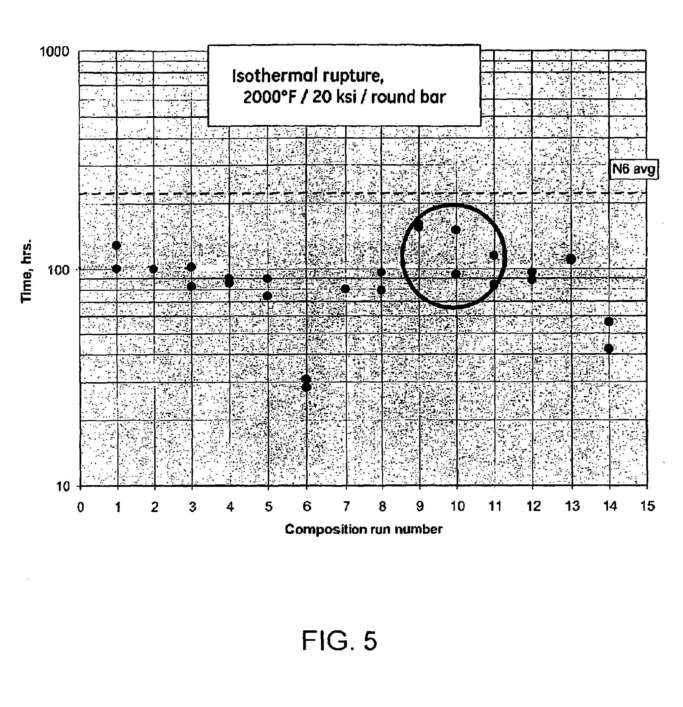

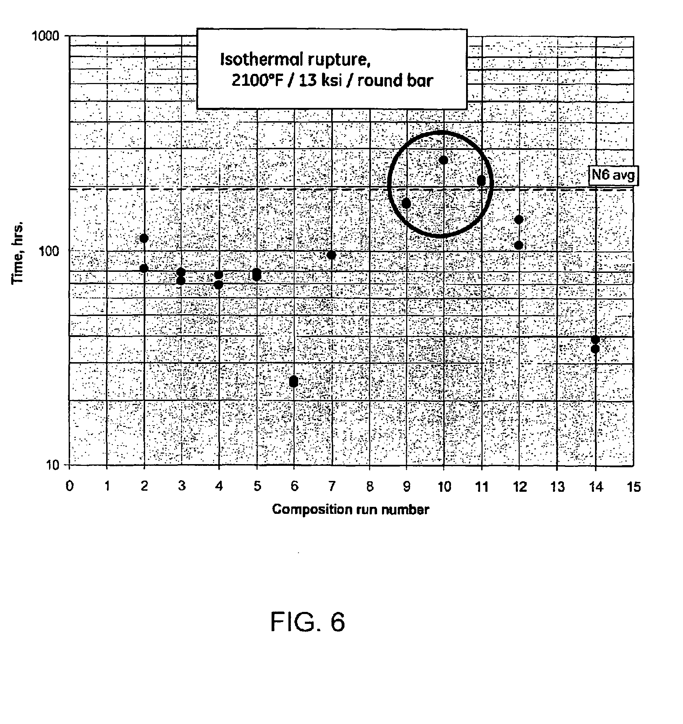

Figures 4-6 are graphs plotting time to stress rupture for Alloys 1-14 in comparison to historical averages for N6 ("N6 avg"). Samples from each alloy were machined to form conventional creep test specimens and stress rupture tested in accordance with ASTM E139 at stress and temperature combinations of about 40 ksi (about 276 MPa) and about 1800°F (about 980°C), about 20 ksi (about 138 MPa) and about 2000°F (about 1090°C), and about 13 ksi (about 90 MPa) and about 2100°F (about 1150°C). Specimens from all but one alloy exhibited stress rupture strength approaching N6 at 1800°F, and Alloys 9, 10, and 11 exhibited the best overall stress rupture performance at the three test temperatures.

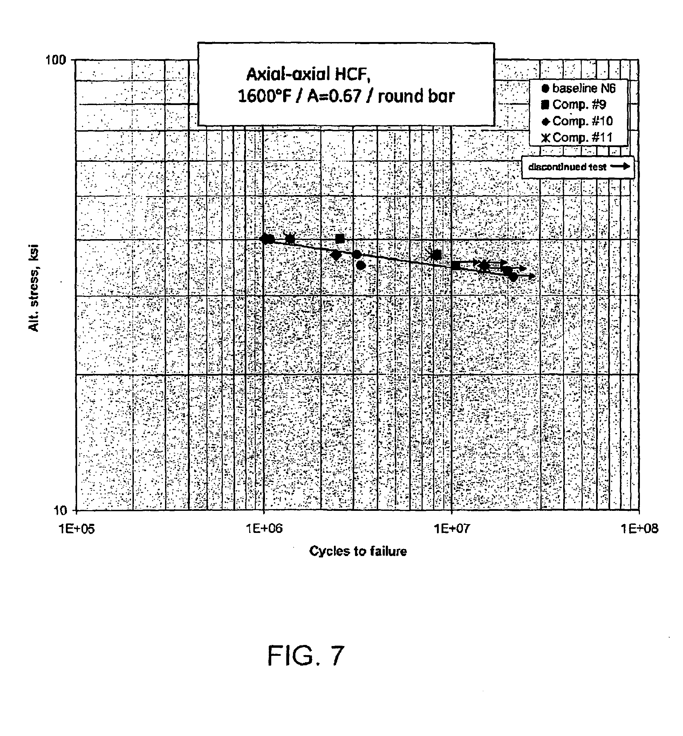

Figure 7 is a graph plotting axial-axial high cycle fatigue (HCF) life at about 1600°F (about 870°C) for Alloys 9, 10, and 11 in comparison to N6 baseline data. The HCF tests were conducted under the stress-controlled condition and about 60 Hz cyclic loading. The data indicate that the HCF lives of Alloys 9, 10, and 11 were equal or better than the N6 baseline at the temperature tested.

On the basis of Alloys 9, 10, 11, an alloy having the approximate broad and nominal compositions (by weight) summarized in Table II is believed to have properties similar to N6 and therefore suitable for use as an alloy for hot gas path components of gas turbine engines, as well as other applications in which similar properties are required. The densities of Alloys 9, 10, and 11 were about 0.319 lbs/in$^3$ (about 8.82 g/cm$^3$), about 0.316 lbs/in$^3$ (about 8.74 g/cm$^3$), and about 0.317 lbs/in$^3$ (about 8.77 g/cm$^3$), respectively. It is believed that an alloy within the ranges set forth in Table II can be satisfactorily heat treated using the treatment described above.

<div align="center">

TABLE II

| | BROAD | PREFERRED | NOMINAL |
|---|---|---|---|
| Al | 5.75 to 6.5 | 6.00 to 6.5 | 6.125 |
| Ta | 4.0 to 5.0 | 4.0 to 5.0 | 4.5 |
| Cr | 2.0 to 6.0 | 2.0 to 6.0 | 4.2 |
| W | 5.5 to 7.0 | 5.5 to 7.0 | 6.5 |
| Mo | 1.5 to 3.0 | 1.5 to 3.0 | 1.5 |
| Re | 4.0 to 5.0 | 4.0 to 5.0 | 4.5 |
| Nb | 0 to 1.0 | 0.5 to 1.0 | 0.75 |
| Co | 10.0 to 16.0 | 10.0 to 12.0 | 10.0 |
| Ti | 0 to 1.0 | 0.25 to 1.0 | 0.3 |
| C | 0.01 to 0.05 | 0.01 to 0.05 | 0.03 |
| B | 0 to 0.005 | 0.001 to 0.005 | 0.004 |
| Y | 0 to 0.01 | 0 to 0.01 | 0.004 |
| Hf | 0.5 to 1.0 | 0.5 to 1.0 | 0.60 |
| Ni | balance | balance | balance |

</div>

It should be noted that the relative amounts of niobium, tantalum, tungsten, and rhenium appeared to be particularly important for both strength and microstructural stability (resistance to TCP formation). Specifically, data obtained with the alloys of Table I coated with diffusion aluminide coatings showed that certain alloys of Table I appeared to exhibit lower incidence of TCP phases if they contained, by weight, 0.75% (e.g., less than 1 %) niobium, 6% (e.g., less than 7%) tungsten, and 4% (e.g., less than 5%) tantalum. On this basis, it was theorized that strength and microstructural stability could be further promoted by adjusting the compositions set forth in Table II to contain, by weight, about 4.0% tantalum, about 6.0% tungsten, and about 5.0% rhenium.

Because of their excellent mechanical properties and low densities, Alloys 9, 10, and 11 were further characterized on the basis of, in comparison to the nominal composition of N6 (Table I), their nominal decreases in the levels of the relatively heavy elements tantalum and rhenium and their nominal increases in the levels of aluminum, tungsten, molybdenum, niobium, titanium, and hafnium levels (of which all but tungsten and hafnium are significantly less dense than tantalum and rhenium). The sums of these increased and decreased levels, designated herein as delta additions and delta reductions, respectively, are summarized for Alloys 9, 10, and 11 in Table III, as is the ratio of delta additions to delta reductions for each alloy (delta ratio).

TABLE III

|  | ALLOY 9 | ALLOY 10 | ALLOY 11 | ALLOY 14 |
|---|---|---|---|---|
| $\varepsilon$Al | 0.25 | 0.50 | 0.25 | 0.375 |
| $\varepsilon$W | 1.2 | 0.2 | 0.2 | 0.7 |
| $\varepsilon$Mo | 0.1 | 0.1 | 0.1 | 0.1 |
| $\varepsilon$Nb | 0.75 | 0.75 | 0.75 | 1.13 |
| $\varepsilon$Ti | 0.3 | 0.3 | 0.3 | 0.3 |
| $\varepsilon$Hf | 0.4 | 0.4 | 0.4 | 0.4 |
| Delta Addition | 3.0 | 2.25 | 2.0 | 3.005 |
|  |  |  |  |  |
| $\varepsilon$Ta | 3.2 | 3.2 | 2.2 | 1.7 |
| $\varepsilon$Re | 0.4 | 0.4 | 1.4 | 0.9 |
| Delta Reduction | 3.6 | 3.6 | 3.6 | 2.6 |
|  |  |  |  |  |
| Delta Ratio | 0.83 | 0.62 | 0.55 | 1.15 |

From the above, it can be seen that the delta ratios of Alloys 9, 10, and 11 were less than one. For comparison, the delta ratio of Alloy 14 is also calculated in Table III. In view of these results, it was concluded that the delta ratios of the alloys could be used as indicators of their abilities to exhibit desirable mechanical properties relative to their densities, with lower delta ratios evidencing lower densities as compared to N6. Based on the nominal composition of N6 as set forth in Table I, the calculation of the delta ratio for alloys within the scope of this invention can be made using the following formulas:

$$\text{Delta Ratio} = (\text{Al-}5.75 + \text{W-}5.8 + \text{Mo-}1.4 + \text{Nb} + \text{Ti} + \text{Hf-}0.2)/(7.2\text{-Ta} + 5.4\text{-Re})$$

or

$$(\text{Al} + \text{W} + \text{Mo} + \text{Nb} + \text{Ti} + \text{Hf} - 13.15)/(12.6 - \text{Ta} - \text{Re})$$

A second round of alloys was then identified for further testing based on the knowledge gained from the first round. The alloying levels for the second round of alloys identified as Alloys 15-25 in Table IV below were selected to evaluate the affects of limiting tantalum and niobium levels to the minimum present in Alloys 9, 10, and 11, reducing the tungsten content, and increasing the molybdenum content. In part, the approach taken with Alloys 15-25 is to approximately maintain levels of gamma prime-forming elements similar to that nominally contained in N6 (about 15.8 atomic percent of aluminum, tantalum, niobium, titanium, and hafnium combined) without increasing density. Alloys 15-25 also reflect the intent to maintain a delta ratio of less than one.

TABLE IV

|  | Al | Ta | Cr | W | Mo | Re | Nb | Co | Ti | Ru | C | B | Y | Hf |
|---|---|---|---|---|---|---|---|---|---|---|---|---|---|---|
| N6 | 5.75 | 7.2 | 4.2 | 5.5 | 1.4 | 5.4 | -- | 12.5 | -- | -- | 0.05 | 0.004 | 0.01 | 0.2 |
| 15 | 6.1 | 4.0 | 4.2 | 5.5 | 2.25 | 4.5 | 0.75 | 10.0 | 0.3 | 0.0 | 0.03 | 0.004 | 0.004 | 0.6 |
| 16 | 6.1 | 4.0 | 4.2 | 6.0 | 3.00 | 4.5 | 0.75 | 10.0 | 0.3 | 0.0 | 0.03 | 0.004 | 0.004 | 0.6 |
| 17 | 6.1 | 4.0 | 4.2 | 6.0 | 2.25 | 4.5 | 0.75 | 10.0 | 0.3 | 0.0 | 0.03 | 0.004 | 0.004 | 0.6 |
| 18 | 6.1 | 4.0 | 4.2 | 5.5 | 3.00 | 5.0 | 0.75 | 10.0 | 0.3 | 0.0 | 0.03 | 0.004 | 0.004 | 0.6 |

(continued)

|    | Al  | Ta  | Cr  | W   | Mo   | Re  | Nb   | Co   | Ti  | Ru  | C    | B     | Y     | Hf  |
|----|-----|-----|-----|-----|------|-----|------|------|-----|-----|------|-------|-------|-----|
| 19 | 6.1 | 4.0 | 4.2 | 5.5 | 2.25 | 5.0 | 0.75 | 10.0 | 0.3 | 0.0 | 0.03 | 0.004 | 0.004 | 0.6 |
| 20 | 6.1 | 4.0 | 4.2 | 6.0 | 3.00 | 5.0 | 0.75 | 10.0 | 0.3 | 0.0 | 0.03 | 0.004 | 0.004 | 0.6 |
| 21 | 6.1 | 4.0 | 4.2 | 6.0 | 2.25 | 5.0 | 0.75 | 10.0 | 0.3 | 0.0 | 0.03 | 0.004 | 0.004 | 0.6 |
| 22 | 6.1 | 4.0 | 4.2 | 6.0 | 3.00 | 5.0 | 0.75 | 10.0 | 0.3 | 0.0 | 0.03 | 0.004 | 0.004 | 0.6 |
| 23 | 6.1 | 4.0 | 4.2 | 6.0 | 1.50 | 5.0 | 0.40 | 10.0 | 0.5 | 0.0 | 0.03 | 0.004 | 0.004 | 0.6 |
| 24 | 6.1 | 4.0 | 4.2 | 6.0 | 1.50 | 5.0 | 0.75 | 10.0 | 0.5 | 0.0 | 0.03 | 0.004 | 0.004 | 0.6 |
| 25 | 6.1 | 4.0 | 4.0 | 6.5 | 2.25 | 5.0 | 0.75 | 10.0 | 0.3 | 0.0 | 0.03 | 0.004 | 0.004 | 0.6 |

Alloys 15-25 can generally be summarized as covering the ranges and nominal compositions (by weight) summarized in Table V below.

TABLE V

|     | RANGE          | NOMINAL |
|-----|----------------|---------|
| Al  | 6.00 to 6.25   | 6.1     |
| Ta  | 4.0 to 5.0     | 4.0     |
| Cr  | 2.0 to 6.0     | 4.2     |
| W   | 6.0 to 7.0     | 6.0     |
| Mo  | 1.5 to 3.0     | 2.25    |
| Re  | 4.0 to 5.0     | 4.75    |
| Nb  | 0.5 to 1.0     | 0.75    |
| Co  | 10.0 to 12.0   | 10.0    |
| Ti  | 0.25 to 1.0    | 0.3     |
| C   | 0.01 to 0.05   | 0.03    |
| B   | 0.001 to 0.005 | 0.004   |
| Y   | 0 to 0.01      | 0.004   |
| Hf  | 0.5 to 1.0     | 0.60    |
| Ni  | balance        | balance |

Preparation of Alloys 15-25 for testing is currently underway.

**Claims**

1. A single-crystal casting (10) formed of a nickel-base alloy consisting of, by weight:

5.75% to 6.5% aluminum;
4.0% up to 5.0% tantalum;
2.0% to 6.0% chromium;
5.5% to 7.0% tungsten;
1.5% to 3.0% molybdenum;
4.0% to 5.0% rhenium;
up to 1.0% niobium;
10.0% to 16.0% cobalt;
up to 1.0% titanium;
0.01% to 0.05% carbon;
up to 0.005% boron;
up to 0.01 % yttrium;
0.5% to 1.0% hafnium;
the balance nickel and incidental impurities;
wherein the density of the alloy is not greater than 8.87g/cm$^3$ (0.32 lb/in$^3$) and the alloy has a delta ratio of less than one calculated with the formula

$$(Al + W + Mo + Nb + Ti + Hf - 13.15)/(12.6 - Ta - Re)$$

wherein Al, W, Mo, Nb, Ti, Hf, Ta, and Re are the levels of aluminum, tungsten, molybdenum, niobium, titanium, hafnium, tantalum, and rhenium, respectively, in weight percent.

2. The single-crystal casting (10) according to claim 1, **characterized in that** the alloy consists of, by weight, 6.0 to 6.25% aluminum, 4.0 to 5.0% tantalum, 2.0 to 6.0% chromium, 5.5 to 7.0% tungsten, 1.5 to 3.0% molybdenum, 4.0 to 5.0% rhenium, 0.5 to 1.0% niobium, 10.0 to 12.0% cobalt, 0.25 to 1.0% titanium, 0.01 to 0.05% carbon, 0.001 to 0.005% boron, 0 to 0.01% yttrium, 0.5 to 1.0% hafnium, the balance nickel and incidental impurities.

3. The single-crystal casting (10) according to claim 1, **characterized in that** the alloy contains of, by weight, 4.0% tantalum, 6.0% tungsten, and 5.0% rhenium.

4. The single-crystal casting (10) according to claim 1, **characterized in that** the alloy consists of, by weight:

6.00% to 6.25% aluminum;
4.0% up to 5.0% tantalum;
2.0% to 6.0% chromium;
6.0% up to 7.0% tungsten;
1.5% to 3.0% molybdenum;
4.0% to 5.0% rhenium;
0.5% to 1.0% niobium;
10.0% to 12.0% cobalt;
0.25% to 1.0% titanium;
0.01 % to 0.05% carbon;
0.001% to 0.005% boron;
up to 0.01 % yttrium;
0.5% to 1.0% hafnium;
the balance nickel and incidental impurities;
and the density of the alloy is less than 8.87g/cm$^3$(0.32 lb/in$^3$).

5. The single-crystal casting (10) according to claim 4, **characterized in that** the alloy consists of, by weight, 6.1 % aluminum, 4.0% tantalum, 4.0 to 4.2% chromium, 5.5 to 6.5% tungsten, 1.50 to 3.0% molybdenum, 4.5 to 5.0% rhenium, 0.75% niobium, 10.0% cobalt, 0.3 to 0.5% titanium, 0.03% carbon, 0.004% boron, 0.004% yttrium, 0.6% hafnium, the balance nickel and incidental impurities.

6. The single-crystal casting (10) according to any one of the preceding claims, **characterized in that** the molybdenum content in the alloy is greater than 2.0 weight percent.

7. The single-crystal casting (10) according to any one of the preceding claims, **characterized in that** the molybdenum content in the alloy is greater than 2.25 weight percent.

8. The single-crystal casting (10) according to any one of the preceding claims, **characterized in that** the alloy has a density of 8.73 to 8.849g/cm$^3$ (0.315 to 0.318 lbs/in$^3$).

9. The single-crystal casting (10) according to any one of the preceding claims, **characterized in that** the alloy has a delta ratio of less than 0.9.

10. The single-crystal casting (10) according to any one of the preceding claims, **characterized in that** the casting (10) is a gas turbine engine component (10).

**Patentansprüche**

1. Einkristallformling (10) geformt aus einer Nickellegierung bestehend nach Gewicht aus:

   5,75% bis 6,5% Aluminium;
   4,0% bis 5,0% Tantal;
   2,0% bis 6,0% Chrom;
   5,5% bis 7,0% Wolfram;
   1,5% bis 3,0% Molybdän;
   4,0% bis 5,0% Rhenium;
   bis zu 1,0% Niob;
   10,0% bis 16,0% Kobalt;
   bis zu 1,0% Titan;
   0,01% bis 0,05% Kohlenstoff;
   bis zu 0,005% Bor;
   bis zu 0,01 % Yttrium;
   0,5% bis 1,0% Hafnium;
   der Rest Nickel und zufällige Verunreinigungen;
   wobei die Dichte der Legierung nicht größer als 8,87 g/cm$^3$ (0,32 lb/in$^3$) ist und die Legierung ein Deltaverhältnis von weniger als 1 hat berechnet mit der Formel

$$(Al + W + Mo + Nb + Ti + Hf - 13,15)/(12,6 - Ta - Re)$$

   worin Al, W, Mo, Nb, Ti, Hf, Ta und Re den Gehalt an Aluminium, Wolfram, Molybdän, Niob, Titan, Hafnium, Tantal bzw. Rhenium in Gewichtsprozent angeben.

2. Einkristallformling (10) nach Anspruch 1, **dadurch gekennzeichnet, dass** die Legierung nach Gewicht besteht aus 6,0 bis 6,25% Aluminium, 4,0 bis 5,0% Tantal, 2,0 bis 6,0% Chrom, 5,5 bis 7,0% Wolfram, 1,5 bis 3,0% Molybdän, 4,0 bis 5,0% Rhenium, 0,5 bis 1,0% Niob, 10,0 bis 12,0% Kobalt, 0,25 bis 1,0% Titan, 0,01 bis 0,05% Kohlenstoff, 0,001 bis 0,005% Bor, 0 bis 0,01% Yttrium, 0,5 bis 1,0% Hafnium, wobei der Rest Nickel und zufällige Verunreinigungen sind.

3. Einkristallformling (10) nach Anspruch 1, **dadurch gekennzeichnet, dass** die Legierung 4,0% Tantal, 6,0% Wolfram und 5,0% Rhenium nach Gewicht enthält.

4. Einkristallformling (10) nach Anspruch 1, **dadurch gekennzeichnet, dass** die Legierung nach Gewicht aus:

   6,00% bis 6,25% Aluminium;
   4,0% bis zu 5,0% Tantal;
   2,0% bis 6,0% Chrom;
   6,0% bis 7,0% Wolfram;
   1,5% bis 3,0% Molybdän;
   4,0% bis 5,0% Rhenium;

0,5% bis 1,0% Niob;
10,0% bis 12,0% Kobalt;
0,25% bis 1,0% Titan;
0,01 % bis 0,05% Kohlenstoff;
0,001% bis 0,005% Bor;
bis zu 0,01 % Yttrium;
0,5% bis 1,0% Hafnium;
der Rest Nickel und zufällige Verunreinigungen;
besteht
und die Dichte der Legierung kleiner als 8,87 g/cm$^3$ (0,32 lb/in$^3$).

5. Einkristallformling (10) nach Anspruch 4, **dadurch gekennzeichnet, dass** die Legierung aus 6, 1 % Aluminium, 4,0% Tantal, 4,0 bis 4,2% Chrom, 5,5 bis 6,5% Wolfram, 1,50 bis 3,0% Molybdän, 4,5 bis 5,0% Rhenium, 0,75% Niob, 10,0% Kobalt, 0,3 bis 0,5% Titan, 0,03% Kohlenstoff, 0,004% Bor, 0,004% Yttrium, 0,6% Hafnium, der Rest Nickel und zufällige Verunreinigungen nach Gewicht besteht.

6. Einkristallformling (10) nach einem der vorhergehenden Ansprüche, **dadurch gekennzeichnet, dass** der Molybdängehalt in der Legierung größer als 2,0 Gewichtsprozent ist.

7. Einkristallformling (10) nach einem der vorhergehenden Ansprüche, **dadurch gekennzeichnet, dass** der Molybdängehalt in der Legierung größer als 2,25 Gewichtsprozent ist.

8. Einkristallformling (10) nach einem der vorhergehenden Ansprüche, **dadurch gekennzeichnet, dass** die Legierung eine Dichte von 8,73 bis 8,84 g/cm$^3$ (0,315 bis 0,318 lbs/in$^3$) hat.

9. Einkristallformling (10) nach einem der vorhergehenden Ansprüche, **dadurch gekennzeichnet, dass** die Legierung ein Deltaverhältnis von weniger als 0,9 hat.

10. Einkristallformling (10) nach einem der vorhergehenden Ansprüche, **dadurch gekennzeichnet, dass** der Formling (10) eine Gasturbinenmotorkomponente (10) ist.

**Revendications**

1. Pièce moulée (10) monocristalline, en un alliage à base de nickel constitué des éléments suivants (teneurs en pourcentages pondéraux) :

- 5,75 % à 6,5 % d'aluminium ;
- 4,0 % à 5,0 % de tantale ;
- 2,0 % à 6,0 % de chrome ;
- 5,5 % à 7,0 % de tungstène ;
- 1,5 % à 3,0 % de molybdène ;
- 4,0 % à 5,0 % de rhénium ;
- jusqu'à 1,0 % de niobium ;
- 10,0 % à 16,0 % de cobalt ;
- jusqu'à 1,0 % de titane ;
- 0,01 % à 0,05 % de carbone ;
- jusqu'à 0,005 % de bore ;
- jusqu'à 0,01 % d'yttrium ;
- et 0,5 % à 1,0 % de hafnium ;
- le complément étant du nickel et des impuretés accidentelles ; lequel alliage présente une masse volumique d'au plus 8,87 g/cm$^3$ (0,32 livre par pouce cube) et un rapport Delta inférieur à 1, ce rapport étant calculé au moyen de la formule suivante :

$$(Al + W + Mo + Nb + Ti + Hf - 13,15)/(12,6 - Ta - Re)$$

dans laquelle Al, W, Mo, Nb, Ti, Hf, Ta et Re représentent respectivement les teneurs en aluminium, tungstène, molybdène, niobium, titane, hafnium, tantale et rhénium, exprimées en pourcentages pondéraux.

2. Pièce moulée (10) monocristalline, conforme à la revendication 1, **caractérisée en ce que** l'alliage est constitué, en pourcentages pondéraux, de 6,0 à 6,25 % d'aluminium, 4,0 à 5,0 % de tantale, 2,0 à 6,0 % de chrome, 5,5 à 7,0 % de tungstène, 1,5 à 3,0 % de molybdène, 4,0 à 5,0 % de rhénium, 0,5 à 1,0 % de niobium, 10,0 à 12,0 % de cobalt, 0,25 à 1,0 % de titane, 0,01 à 0,05 % de carbone, 0,001 à 0,005 % de bore, 0 à 0,01 % d'yttrium et 0,5 à 1,0 % de hafnium, le complément étant du nickel et des impuretés accidentelles.

3. Pièce moulée (10) monocristalline, conforme à la revendication 1, **caractérisée en ce que** l'alliage contient, en pourcentages pondéraux, 4,0 % de tantale, 6,0 % de tungstène et 5,0 % de rhénium.

4. Pièce moulée (10) monocristalline, conforme à la revendication 1, **caractérisée en ce que** l'alliage est constitué des éléments suivants (teneurs en pourcentages pondéraux) :

   - 6,00 % à 6,25 % d'aluminium ;
   - 4,0 % à 5,0 % de tantale ;
   - 2,0 % à 6,0 % de chrome ;
   - 6,0 % à 7,0 % de tungstène ;
   - 1,5 % à 3,0 % de molybdène ;
   - 4,0 % à 5,0 % de rhénium ;
   - 0,5 % à 1,0 % de niobium ;
   - 10,0 % à 12,0 % de cobalt ;
   - 0,25 % à 1,0 % de titane ;
   - 0,01 % à 0,05 % de carbone ;
   - 0,001 % à 0,005 % de bore ;
   - jusqu'à 0,01 % d'yttrium ;
   - et 0,5 % à 1,0 % de hafnium ;
   - le complément étant du nickel et des impuretés accidentelles ; lequel alliage présente une masse volumique inférieure à 8,87 g/cm$^3$ (0,32 livre par pouce cube).

5. Pièce moulée (10) monocristalline, conforme à la revendication 4, **caractérisée en ce que** l'alliage est constitué, en pourcentages pondéraux, de 6,1 % d'aluminium, 4,0 % de tantale, 4,0 à 4,2 % de chrome, 5,5 à 6,5 % de tungstène, 1,50 à 3,0 % de molybdène, 4,5 à 5,0 % de rhénium, 0,75 % de niobium, 10,0 % de cobalt, 0,3 à 0,5 % de titane, 0,03 % de carbone, 0,004 % de bore, 0,004 % d'yttrium et 0,6 % de hafnium, le complément étant du nickel et des impuretés accidentelles.

6. Pièce moulée (10) monocristalline, conforme à l'une des revendications précédentes, **caractérisée en ce que** l'alliage contient plus de 2,0 % en poids de molybdène.

7. Pièce moulée (10) monocristalline, conforme à l'une des revendications précédentes, **caractérisée en ce que** l'alliage contient plus de 2,25 % en poids de molybdène.

8. Pièce moulée (10) monocristalline, conforme à l'une des revendications précédentes, **caractérisée en ce que** l'alliage présente une masse volumique de 8,73 à 8,84 g/cm$^3$ (0,315 à 0,318 livre par pouce cube).

9. Pièce moulée (10) monocristalline, conforme à l'une des revendications précédentes, **caractérisée en ce que** l'alliage présente un rapport Delta inférieur à 0,9.

10. Pièce moulée (10) monocristalline, conforme à l'une des revendications précédentes, **caractérisée en ce que** cette pièce (10) est un composant de moteur à turbine à gaz.

FIG. 1

## FIG. 2

0.2% yield strength, round bar

Stress, ksi

N6 avg

Composition run number

## FIG. 3

UTS, round bar

Stress, ksi

N6 avg

Composition run number

FIG. 4

FIG. 5

**FIG. 6**

FIG. 7

**REFERENCES CITED IN THE DESCRIPTION**

**Patent documents cited in the description**

- US 5455120 A
- EP 1394278 A